(19) Europäisches Patentamt
European Patent Office
Office européen des brevets

(11) **EP 3 226 271 B1**

(12) **EUROPEAN PATENT SPECIFICATION**

(45) Date of publication and mention of the grant of the patent:
**17.03.2021 Bulletin 2021/11**

(51) Int Cl.:
*H01G 9/16* *(2006.01)*    *H01G 9/028* *(2006.01)*
*H01L 51/05* *(2006.01)*    *G11C 11/22* *(2006.01)*
*H01L 51/00* *(2006.01)*

(21) Application number: **17164242.4**

(22) Date of filing: **31.03.2017**

(54) **ELECTROCHEMICAL DEVICE**

ELEKTROCHEMISCHE VORRICHTUNG

DISPOSITIF ÉLECTROCHIMIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **01.04.2016 EP 16163523**

(43) Date of publication of application:
**04.10.2017 Bulletin 2017/40**

(73) Proprietor: **RISE Research Institutes of Sweden AB**
**501 15 Borås (SE)**

(72) Inventors:
• **FABIANO, Simone**
**602 31 NORRKÖPING (SE)**
• **CRISPIN, Xavier**
**610 20 KIMSTAD (SE)**
• **BERGGREN, Magnus**
**602 18 NORRKÖPING (SE)**
• **ABDOLLAHI SANI, Negar**
**603 37 NORRKÖPING (SE)**
• **KAWAHARA, Jun**
**TOKYO, 173-0001 (JP)**

(74) Representative: **AWA Sweden AB**
**P.O. Box 45086**
**104 30 Stockholm (SE)**

(56) References cited:
**EP-A1- 1 798 732    EP-A1- 2 779 261**
**US-A1- 2004 256 644    US-A1- 2006 160 251**
**US-A1- 2013 328 026**

• **GELINCK G ET AL: "All-polymer ferroelectric transistors", APPLIED PHYSICS LETTERS, A I P PUBLISHING LLC, US, vol. 87, no. 9, 23 August 2005 (2005-08-23), pages 92903-092903, XP012077631, ISSN: 0003-6951, DOI: 10.1063/1.2035324**
• **SBORIKAS MARTYNAS ET AL: "Piezo- and ferroelectric P(VDF-TrFE) films with inkjet-printed PEDOT:PSS electrodes: Preparation parameters and property evaluation", 2014 JOINT IEEE INTERNATIONAL SYMPOSIUM ON THE APPLICATIONS OF FERROELECTRIC, INTERNATIONAL WORKSHOP ON ACOUSTIC TRANSDUCTION MATERIALS AND DEVICES & WORKSHOP ON PIEZORESPONSE FORCE MICROSCOPY, IEEE, 12 May 2014 (2014-05-12), pages 1-4, XP032658565, DOI: 10.1109/ISAF.2014.6923005**

**Description**

Technical field

The invention relates generally to electrochemical devices and more specifically to electrochemical transistors and electrochromic pixels.

Background

Unlike their inorganic counterparts, organic electronic materials provide noteworthy advantages in terms of high elasticity, mechanical flexibility, unlimited number of low-cost synthesis, and solution processability over large areas. The electrical conductivity of conducting polymers depends significantly on the morphology, microstructure and the number of counterions that balance the doping charge carried by the conjugated polymer chains. A promising route towards novel electronics is to utilize the coupling between electron and ion transport in organic molecular or polymeric materials. In a so called electrochemical device in fact, both ions and electrons can be charge carriers. Based on this concept, conducting polymers have widespread uses in varied applications, such as electrode materials for electrochromic display cells (ECDs) and charge-storage batteries. Importantly, the electronic and, thereby, optical properties of these materials can be altered by switching the material between different redox states, which for instance allows tuning of the channel electrical conductivity in electrochemical transistors (ECTs). As a natural consequence, the characteristics of electronic devices based on conducting polymers can be modified on request. However, many electronic applications require elements that include a proper signal addressability, which is typically provided by a nonlinear devices characteristic. Due to the typical capacitive charging behavior of the conducting polymers, it is difficult to dictate threshold voltages into the electrochemistry of these carbon-based materials. This requires then a nonlinear electronic element, such as a switchable ferroelectric diode.

When a ferroelectric material is polarized, the induced polarization, P, is not proportional to the applied external electric field E; it shows an enhanced nonlinear polarization. The nonlinear nature of ferroelectric materials can be used to make capacitors with tunable capacitance. Thus, ferroelectric materials have become an integral part of micro- and nanoscale devices where they enable a great number of advances in the field of electro-optic modulators, mechanical microsensors, and actuators. In this respect, ferroelectric polymers are especially attractive as the active medium for data storage, owing to their high flexibility, low cost and simple production protocol. Ferroelectric thin films can maintain an electric polarization state in the absence of an externally applied electric field. The polarization state and the resulting surface charge density originate from a bistable, switchable dipole moment, maintained across the ferroelectric domains of the material. The net surface charge density can be induced to be either positive or negative depending on the direction of the applied polarizing electric field. It has been proposed that if these surface charges are maintained in aqueous environments, then the resulting electrostatic forces should induce the formation of electrolyte gradients and aid in the localization of charged species to the surfaces. The relevant prior art can be found in: EP 2 779 261 A1, EP 1 798 732 A1, GELINCK G ET AL: "All-polymer ferroelectric transistors",APPLIED PHYSICS LETTERS, A I P PUBLISHING LLC, US, vol. 87, no. 9, 23 August 2005 (2005-08-23), pages 92903-092903, XP012077631,ISSN: 0003-6951, DOI: 10.1063/1.2035324 and US 2006/160251 A1.

Summary of the invention

It is an object of the present disclosure to provide improved electrochemical devices, e.g. electrochemical transistors and electrochromic pixels, according to independent claim 1.

These objects, as well as other objects that will be apparent to the skilled person in the light of the present disclosure, are achieved by a device in accordance with the appended independent claims. Preferred embodiments are defined in the dependent claims.

The inventors have found that the surface charge density expressed by a ferroelectric polymeric thin film induces nonlinearity effects in the current-voltage characteristics of a solution-processed conducting polymer. The ferroelectric polarization triggers the reversible doping/de-doping process of the conducting polymer, which is in contact with a common electrolyte. The voltage applied to the ferroelectric needs to overcome a certain threshold before the electrochemical reaction occurs in the PEDOT:PSS electrode so that a built-in threshold voltage is established in the devices. The induced hysteretic functionality is successfully implemented in novel addressable devices and memory elements such as ferroelectrochromic pixels and displays (FeECDs) and ferroelectrochemical transistors (FeECTs).

The present inventors have further found that the introduction of an ion conductor layer between the electrochemically active polymer layer and the ferroelectric layer of an electrochemical device, such as an electrochemical transistor or electrochromic pixel can significantly improve the properties of the device.

The invention is directed to "electrochemical devices". This should be understood as devices wherein the technical effect, i.e. a change in conductivity and/or color, is achived by means of electrochemical reactions in the electrochemically active material. Electrochemical devices are different from pure field-effect based devices wherein the change in properties is brought about by the application of an electric field without electrochemical reactions occurring in the electrochemically active material.

According to a first aspect the invention provides an electrochemical device comprising:

an electrochemically active polymer layer;

a ferroelectric layer; and

an ion conductor layer arranged between said electrochemically active layer and said ferroelectric layer and in contact with the electrochemically active layer.

The invention aims to develop addressable electrochemical devices by the introduction of a threshold voltage in the I-V characteristic of electrochemically active polymer electrodes. Specifically, the invention enables the possibility to address electrochromic pixels arranged into a passive matrix display with reduced cross-talk effects. Furthermore, the invention can be used to develop reprogrammable non-volatile memories with non-destructive read-out, long data retention and low-cost manufacturing based on electrochemical transistors.

According to some embodiments, the electrochemical device according to claim 1, further comprises:

an electrode arranged in electronic contact with the said ferroelectric layer;

said ferroelectric layer being arranged between said electrode and said ion conductor layer.

According to some embodiments, the electrochemical device is an electrochromic pixel. The electrochromic pixel comprises:

an electrochemically active polymer layer;

a ferroelectric layer; and

an ion conductor layer arranged between said electrochemically active layer and said ferroelectric layer and in contact with the electrochemically active layer, wherein the electrochemically active polymer layer is electrochromic.

The electrochemistry of conductive polymers such as PEDOT:PSS does not show any threshold voltage when PEDOT:PSS is used as both the counter electrode and pixel electrode of an electrochromic pixel. Hence, passive matrix addressing of electrochromic pixels based on PEDOT:PSS is not possible since adjacent pixels will be charged as well.

Passive matrix addressed electrochromic displays can be manufactured by combining a conducting carbon-based layer as the counter electrode of the electrochromic pixel, while PEDOT:PSS serves as the pixel electrode material. This material combination results in an electrochromic pixel in which the applied voltage needs to pass a certain threshold before the electrochromic reaction occurs.

Active matrix addressing is an alternative addressing method available for electrochromic pixels. Unique pixel addressing is possible since a transistor is connected in series with each pixel, which controls the current flow to/from the pixel moiety. The fact that PEDOT:PSS is used as the active material in both pixels and transistors is advantageous from a production point of view. However, creating an active matrix addressed display requires many printed layers as compared to displays updated by passive matrix addressing. The consequence of printing such multi-layered structures is that registration and reproducibility becomes a major issue.

According to embodiments of the present invention, a ferroelectric layer is used as the counter electrode of the electrochemical devices (electrochromic pixel or electrochemical transistor), while the electrochemically active polymer (e.g. PEDOT:PSS) serves as the electrode material. This material combination results in an electrochromic pixel in which the applied voltage needs to pass a certain threshold before the electrochromic reaction occurs. In addition, it introduces memory functionality in electrochemical transistors.

According to some embodiments, the electrochemical device is an electrochemical transistor further comprising:

a source electrode arranged in electronic contact with the said electrochemically active layer;

a drain electrode arranged in electronic contact with the said electrochemically active layer; and

a gate electrode;

said ferroelectric layer being arranged between said gate electrode and said ion conductor layer.

It is preferred that the surface charge of the ferroelectric layer in contact with the ion conductor layer is sufficiently large in relation to the total bulk charge of the electrochemically active layer, such that polarization of the ferroelectric layer will generate a sufficient amount of charges to switch the electrochemically active layer to a different electronic state. The surface charge of the ferroelectric layer will only exhibis small variations with the ferroelectric layer thickness, particularly in the preferred thickness range of 60-200 nm, whereas the bulk charge of the electrochemically active layer, being a bulk property, will be dictated by the thickness (or volume) of the electrochemically active layer.

By the term surface charge as used herein in connection with the ferroelectric layer, is meant the total charge which can be generated at a defined surface of the ferroelectric layer when the ferroelectric layer is polarized. The total surface charge is obtained by multiplying the surface charge density and total surface area of the ferroelectric layer in contact with the ion conductor layer. The surface charge density of a ferroelectric layer can be determined by electric displacement loops versus electric field for the capacitors using a Sawyer-Tower circuit

By the term bulk charge as used herein in connection with the electrochemically active layer, is meant the amount of charge that can be can be stored within the electrochemically active layer. The bulk charge density and bulk charge of an electrochemically active layer can be determined by cyclic voltammetry.

Thus, in some embodiments the ratio between the ferroelectric layer surface charge and the electrochemically active layer bulk charge is at least 1:1, preferably larger than 1:1, larger than 2:1, larger than 4:1, larger than 8:1, or larger than 10:1. In a preferred embodiment, the ratio between the ferroelectric layer surface charge and the electrochemically active layer bulk charge is larger than 1:1.

In order to achieve the desired ratio between the ferroelectric layer surface charge and the electrochemically active layer bulk charge, size and the geometry, of the electrochemically active layer can be adjusted. For example, the total volume of the electrochemically active layer can be reduced, and/or the total surface area of the ferroelectric layer in contact with the ion conductor layer can be increased.

In order to obtain a sufficient amount of ion migration in the ion conductor layer upon polarization of the ferroelectric layer to switch the electrochemically active layer to a different electronic state, it may sometimes be necessary to have a ferroelectric layer:electrochemically active layer area ratio larger than 1:1. This means that the surface area of the ferroelectric layer in contact with the ion conductor layer is larger than the surface area of the electrochemically active layer in contact with the ion conductor layer. This way the amount of ion migration generated in the ion conductor layer and introduced into the electrochemically active layer upon polarization of the ferroelectric layer can be increased.

As an example, as the typical bulk charge density of PEDOT:PSS film having a thickness of 100-200 nm and oxidation level of ca. 30% may be about 100-300 $\mu$C cm$^{-2}$, a P(VDF-TrFE):PEDOT area ratio larger than 10:1 may be used to switch the PEDOT:PSS bulk in between the different electronic states.

In some embodiments, a ferroelectric layer:electrochemically active layer area ratio larger than 1:1 may be used. In some embodiments, the ferroelectric layer:electrochemically active layer area ratio is larger than 1:1, larger than 2:1, larger than 4:1, larger than 8:1, or larger than 10:1.

The electrochemical device is further advantageous in that it can be realized from organic materials. Particularly at least one of the layers of the device may be organic, i.e. the electrochemically active polymer layer, the ferroelectric layer and the ion conductor layer.

According to some embodiments, the electrochemically active polymer, the ferroelectric and/or the ion conductor comprise organic materials. According to a preferred embodiment, the electrochemically active polymer, the ferroelectric and the ion conductor all comprise organic materials.

One advantage of using organic materials in the electrochemical device is that it may allow of manufacturing flexible electronic devices.

A further advantage of using organic materials in the device is that such organic materials are generally suitable for being applied to a substrate using liquid deposition techniques. Preferably, at least one of the electrochemically active polymer, the ferroelectric and/or the ion conductor may be applied by liquid deposition techniques.

According to an embodiment, the electrochemically active polymer, the ferroelectric and/or the ion conductor can be applied by liquid deposition techniques. According to a preferred embodiment, the electrochemically active polymer, the ferroelectric and the ion conductor can all be applied by liquid deposition techniques.

One group of compounds useful in the different layers is polymers. According to an embodiment, the electrochemically active polymer, the ferroelectric and the ion conductor all comprise polymers.

According to an embodiment, the electrochemically active polymer layer comprises an organic material having the ability of altering its electrical conductivity and/or optical characteristics upon electrochemical switching of its redox state.

According to an embodiment, the electrochemically active polymer layer comprises a polymer which is electrically conducting in at least one oxidation state, and optionally also comprises an anionic or polyanionic compound.

According to an embodiment, the electrochemically active polymer layer comprises a p-type conducting polymer combined with an anionic or polyanionic compound.

According to an embodiment, the electrochemically active polymer layer comprises an n-type conducting polymer combined with a cationic or polycationic compound.

According to an embodiment, the electrochemically active polymer layer comprises an electrochromic polymer, i.e. a polymer capable of color change associated change of reduction/oxidation state.

According to an embodiment, the electrochemically active polymer layer comprises a polymer selected from the group consisting of electrochromic polythiophenes, electrochromic polypyrroles, electrochromic polyanilines, electrochromic polyisothianaphthalenes, electrochromic polyphenylene vinylenes and copolymers thereof.

According to an embodiment, the electrochemically active polymer layer comprises a polymer selected from the group consisting of a homopolymer or copolymer of a 3,4-dialkoxythiophene, in which said two alkoxy groups may be the same or different or together represent an optionally substituted oxy-alkylene-oxy bridge.

According to an embodiment, the electrochemically active polymer layer comprises a polymer selected from the group consisting of a homopolymer or copolymer of a 3,4-dialkoxythiophene selected from the group consisting of poly(3,4-methylenedioxythiophene), poly(3,4-methylenedioxythiophene) derivatives, poly(3,4-ethylenedioxythiophene), poly(3,4-ethylenedioxythiophene) derivatives, poly(3,4-propylenedioxythiophene), poly(3,4-propylenedioxythiophene) derivatives, poly(3,4-butylenedioxythiophene), poly(3,4-butylenedioxythiophene) derivatives, and copolymers therewith.

According to an embodiment, the electrochemically active polymer layer further comprises a polyanionic compound, preferably poly(styrene sulfonate).

According to an embodiment, the ferroelectric layer comprises a ferroelectric polymer.

According to an embodiment, the ion conductor layer comprises a polymeric electrolyte.

According to an embodiment, the electrochemical device further comprises a metal interlayer, said metal interlayer being arranged between the ion conductor layer and the ferroelectric layer. The metal interlayer prevents migration of ions from the ion conductor layer into the ferroelectric layer.

According to an embodiment, the electrochemical device further comprises a polymeric interlayer, said polymeric interlayer being arranged between said second electrode, or gate electrode, and said ferroelectric layer. The polymer of the polymeric interlayer, which may for example comprise a polyelectrolyte, protects the thin ferroelectric layer from damage when the gate electrode is applied and may also provide improved adhesion between the ferroelectric layer and the gate electrode. Also, when a polyelectrolyte is used, the higher hydrophilicity of the polyelectrolyte interlayer facilitates deposition of polymeric gate electrodes by ink-jet printing tecnique. A polymeric interlayer can also prevent diffusion of metal from a metal gate electrode into the ferroelectric layer, thereby reducing the leakage current.

According to an embodiment, the electrochemical device is arranged on a suitable substrate. According to a preferred embodiment, the electrochemical device is arranged on a flexible solid substrate, e.g. a flexible plastic substrate.

The electrochemical devices of the present disclosure also allows for simple and low-cost manufacturing. For example, device arrays comprising simple cross-bar architectures obtainable by solution based manufacturing processes. Since all the functional materials for fabricating electrochemical devices can be solution based, it is feasible to implement the devices on a flexible substrate by printing or other liquid deposition techniques.

According to a fourth aspect the invention provides use of an ion conductor layer between a ferroelectric layer and an electrochemically active polymer layer of an electrochemical device to introduce a threshold voltage for initiating an electrochemical reaction in the electrochemically active polymer layer.

According to some embodiments, the electrochemical device is an electrochromic pixel.

According to some embodiments, the electrochemical device is an electrochemical transistor.

The above described and other features are exemplified by the following figures and detailed description.

Brief description of the drawings

Referring now to the figures, which are exemplary embodiments, and wherein the like elements are numbered alike:

Figure 1 schematically illustrates a cross-section of an electrochemical device according to the invention.
Figure 2 schematically illustrates a cross-section of an electrochemical device according to the invention.
Figures 3-7 schematically illustrate a cross-section of a transistor according to the invention in bottom gate configuration.
Figure 8 schematically illustrates a cross-section of a transistor according to the invention in bottom gate configuration.
Figure 9 schematically illustrates the chemical structures of PEDOT:PSS (Fig. 9a) and P(VDF-TrFE) (Fig. 9b).
Figure 10 describes the electrical characteristics of PEDOT:PSS. Figure 10a shows I-V characteristics of a typical PEDOT:PSS/electrolyte/PEDOT:PSS device at 0.4 Vs$^{-1}$. Figure 10b shows reduction of pristine PEDOT:PSS electrodes at -0.8 V.

Figure 11 shows the typical I-V characteristic for a capacitor with a 140 $\mu$m thick P(VDF-TrFE) ferroelectric layer. Figure 11a shows I-V characteristics of a typical Au/P(VDF-TrFE)/Au device. Figure 11b shows ferroelectric hysteresis loops of a 140-nm-thick layer using a Sawyer-Tower circuit at a 100-Hz applied voltage frequency.

Figure 12 shows the electrical characteristics of a ferroelectric PEDOT:PSS pixel. Figure 12a shows normalized I-V characteristics of a typical PEDOT:PSS/electrolyte/PVDF-TrFE pixel with and without metal interlayer.

Figure 12b shows peak voltage as a function of PVDF-TrFE film thickness for PEDOT:PSS/electrolyte/PVDF-TrFE pixel with and without metal interlayer. Open dots refer to a metal/PVDF-TrFE/metal capacitor. Figure 12c shows optical images of a PEDOT:PSS/electrolyte/PVDF-TrFE pixel.

Figure 13 shows steady-state characteristics of electrochemical transistors.

Figure 13a shows transfer characteristics of an ECT with 100-$\mu$m-long PEDOT:PSS channel (Vd = -0.5V), and Figure 13b shows the associated transconductance. Figure 13c shows transfer characteristics of a ferroelectric ECT with 100-$\mu$m-long PEDOT:PSS channel and 280-nm-thick P(VDF-TrFE) dielectric (Vd = -0.5V), and Figure 13d shows the associated transconductance.

Detailed description of preferred embodiments

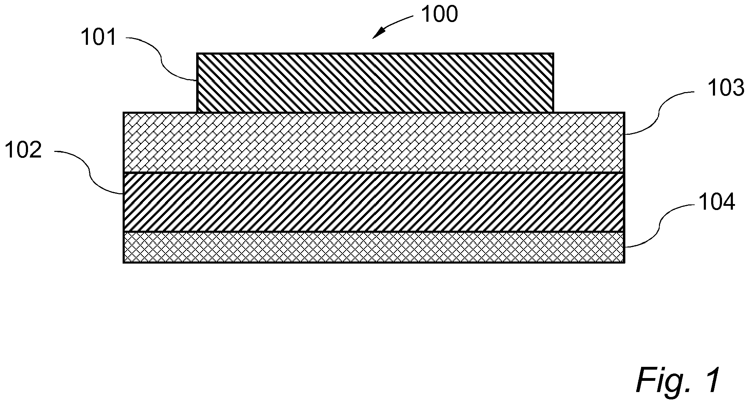

According to an embodiment schematically illustrated in Figure 1, the electrochemical device 100 is an electrochemical pixel comprising an electrochemically active polymer layer 101, a ferroelectric layer 102, and an ion conductor layer 103 arranged between said electrochemically active polymer layer 101 and said ferroelectric layer 102 and in contact with the electrochemically active polymer layer. The device generally further comprises an electrode 104 arranged in electronic contact with the ferroelectric layer.

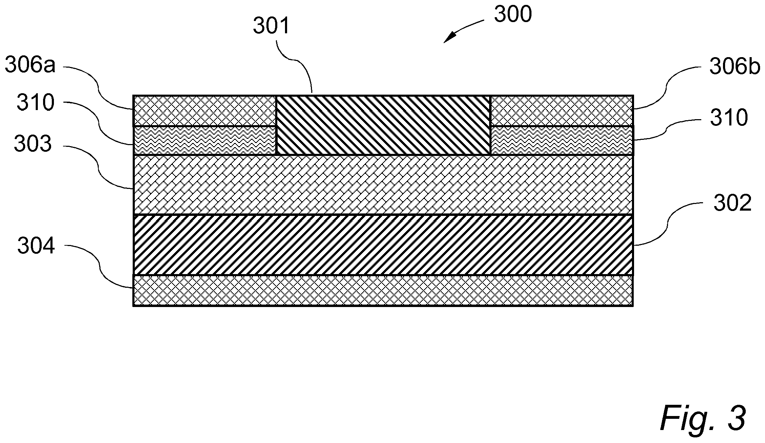

Alternatively, as schematically illustrated in Figure 3, the device may be provided in the form of a transistor structure further comprising two separate electrodes, a source electrode and a drain electrode, arranged in electronic contact with the electrochemically active polymer layer. The electrode arranged in electronic contact with the ferroelectric layer may then be referred to as the gate electrode. The source and drain electrodes are arranged in electronic contact with the electrochemically active polymer layer and the gate electrode is separated from the electrochemically active polymer layer by the ferroelectric layer and ion conductor layer. According to an embodiment, the transistor channel of the electrochemical transistor device is formed of the electrochemically active polymer layer located between a source and a drain electrode. The conductivity of the transistor channel is altered or controlled by changing the oxidation state of the electrochemically active polymer layer. This may be achieved by changing the voltage applied to the gate electrode, whereby ferroelectric polarization of the ferroelectric layer is achieved. The polarization of the ferroelectric layer in turn causes the ions in the ion conductor layer to be redistributed.

The ion conductor layer comprises an ion conductor. An ion conductor is a material capable of conducting ions. The ion conductor may for example comprise an electrolyte. An electrolyte is an electrical conductor in which current is carried by ions rather than by free electrons (as in a metal). The ion conductor layer may consist of a single ion conductor material or a mixture of two or more ion conductor materials. Optionally, the ion conductor layer may further comprise non-ion conductor additives, for example a non-ion conductor polymer.

According to one embodiment of the invention said ion conductor is an organic, organometallic or inorganic electrolyte which dissociates partially in ions. The organic electrolyte is preferably a molecular, macromolecular, oligomeric or polymeric electrolyte, selected from a group comprising for example ionic surfactants or ionic detergents, ionic liquids, fatty acids, aminoacid based molecules and polymers (such as proteins), saccharides or polysaccharides, biomolecules and macromolecules with phosphate groups (e.g. DNA, phosphoglycerides, phospholipids), oligoions or polyions.

According to an embodiment the ion conductor layer comprises polyanions or polymeric anions. According to one embodiment of the invention said ion conductor layer comprises an acid-functional homopolymer or homooligomer or an acid-functional copolymer or cooligomer. In other words, the electrolyte layer of said device is preferably an oligomeric or polymeric acid having at least one acid-functional group.

According to one embodiment of the invention said oligomeric or polymeric acid of said electrolyte layer is an oligomer or polymer of monomer units having phosphonic acid, sulphonic acid, carboxylic acid or phosphoric acid groups. Preferably, said monomer units have phosphonic acid groups, and even more preferred said monomer units are vinylphosphonic acid. Moreover, said monomer units advantageously have sulphonic acid groups, and even more preferred, said monomer units are styrene-4-sulphonic acid or a salt thereof, such as PSSNa poly(sodium 4-styrenesulfonate)

According to another embodiment of the invention said oligomeric or polymeric acid is a cooligomer or copolymer of first comonomer units having phosphonic acid, sulphonic acid, carboxylic acid or phosphoric acid groups, and second comonomer units having phosphonic acid, sulphonic acid, carboxylic acid or phosphoric acid groups, the first and second comonomer units being different. Advantageously, said first co-monomer units have phosphonic acid groups, and even more preferred said first comonomer units are vinyl-phosphonic acid. Moreover, said second comonomer units preferably have carboxylic acid groups, and even more preferred said second comonomer units preferably are acrylic acid. More specifically, said first comonomer units are preferably vinylphosphonic acid and said second comonomer units are preferably acrylic acid, which advantageously is present in the cooligomer or copolymer at a molar ratio of vinylphosphonic acid to acrylic acid of higher than 50:50, preferably higher than 70:30 and even more preferred 85:15.

According to yet another embodiment of the invention said electrolyte is a composition of two or more oligomeric or polymeric acids as defined above. Advantageously, said electrolyte is a composition of a polymer of vinylphosphonic acid and a polymer of acrylic acid, preferably at a molar ratio of vinyl-phosphonic acid to acrylic acid of higher than 70:30. The use of copolymer or cooligomer of vinylphosphonic acid and acrylic acid is advantageous as such substances release a large concentration of protons and have a large proton mobility. Hence, the resulting electrolyte forms the electric double layers faster, which results in a fast response of the transistor.

According to an embodiment illustrated herein the electrolyte layer included in the device comprises an electrolyte selected from polyvinyl alcohol (PVA), poly acrylic acid (PAA), PCPhOH (poly(vinyl phenol), polyvinyl sulphonic acid (PVSH), poly(styrene-4-sulphonic acid (PSSH), polysaccharide, preferably amylase, poly(vinylphosphonic acid-co-acrylic acid (P(VPA-co-AA)), or mixtures thereof. Typically, the polyelectrolyte is poly(vinylphosponic acid-co-acrylic acid (P(VPA-co-AA)).

Preferably the ion conductor comprises an organic material, more preferably said organic material comprises a polymer. The polymer may preferably be a hydrogel based on a polymer selected from the group consisting of polyacrylates, such as poly(2-hydroxyethyl methacrylate) and poly(acrylamide), polyelectrolytes, such as poly(styrene sulfonic acid) (PSS) and poly(acrylic acid) (PAA), polysaccharides, such as agarose and dextran, gelatin and other watersoluble polymers, such as polyvinyl alcohol, polyvinyl pyrrolidone and polyethylene glycol. The ion-conductive channel may also comprise a polyelectrolyte, such as for example poly(styrene sulfonic acid) (PSS) or poly(acrylic acid).

According to an embodiment the ion conductor layer comprises polycations or polymeric cations.

According to one embodiment the ion conductor layer comprises polycations containing primary, secondary and/or tertiary amino groups. According to one embodiment the ion conductor layer comprises poly(ethylenimine), poly(l-lysine), diethylaminoethyl-dextran, poly(vinyl pyridinium bromide).

According to one embodiment the ion conductor layer comprises polymers having quaternary ammonium groups, such as polymers bearing imidazolium groups. Examples are polyquaterniums, such as poly(diallyl-dimethylammonium chloride), and copolymers with quaternized vinylimidazole units, such as poly(3-methyl-1-vinylimidazolium-co-vinylpyrrolidone) chloride.

In the electrochemical device, the ion conductor layer is preferably arranged such that when an electric field is applied across said layer, charge carriers or ions which are available within said layer, will electro-migrate toward the respective surface or side of the material, in accordance with the applied electric field. For instance, available cations will move toward a negatively biased gate electrode. The anions are normally immobile as they are fixed on the polymer (oligomer) chains (resulting in a polyanion).

In order to allow formation of a fully covering ion conductor layer, e.g. free from pinholes, the ion conductor layer may preferably be at least 10 nm thick. The ion conductor layer could also be made much thicker using e.g. printing techniques. The thickness of the ion conductor layer may typically be in the range of 50-200 nm, such as about 130 nm. However, the thickness of the ion conductor layer may also be much higher, such as up to 5 $\mu$m, for example in the range of 1-2 $\mu$m.

The electrochemically active polymer layer of the device may comprise, as electrochemically active and/or electrochromic material, a polymer which is electrically conducting in at least one oxidation state, and may optionally also comprise an anionic or polyanionic compound.

The electrochemically active polymer layer may consist of a single electrochemically active polymer or a mixture of two or more electrochemically active polymers. Optionally, the electrochemically active polymer layer may further comprise non-electrochemically active additives, for example a non-electrochemically active polymer.

Electrochemically active polymers for use in the electrochemical device of the invention are for example selected from the group consisting of polythiophenes, polypyrroles, polyanilines, polyisothianaphthalenes, polyphenylene vinylenes and copolymers thereof. In an embodiment, the electrochemically active polymer is a homopolymer or copolymer of a 3,4-dialkoxythiophene, in which said two alkoxy groups may be the same or different or together represent an optionally substituted oxy-alkylene-oxy bridge. In yet an embodiment, the electrochemically active polymer is a homopolymer or copolymer of a 3,4-dialkoxythiophene selected from the group consisting of poly(3,4-methylenedioxythiophene), poly(3,4-methylenedioxythiophene) derivatives, poly(3,4-ethylenedioxythiophene), poly(3,4-ethylenedioxythiophene) derivatives, poly(3,4-propylenedioxythiophene), poly(3,4-propylenedioxythiophene) derivatives, poly(3,4-butylenedioxythiophene), poly(3,4-butylenedioxythiophene) derivatives, and copolymers therewith. The polyanionic compound is then preferably poly(styrene sulfonate).

Electrochromic polymers for use in an electrochromic pixel of the invention are for example selected from the group consisting of electrochromic polythiophenes, electrochromic polypyrroles, electrochromic polyanilines, electrochromic polyisothianaphthalenes, electrochromic polyphenylene vinylenes and copolymers thereof. In an embodiment, the electrochromic polymer is a homopolymer or copolymer of a 3,4-dialkoxythiophene, in which said two alkoxy groups may be the same or different or together represent an optionally substituted oxy-alkylene-oxy bridge. In yet an embodiment, the electrochromic polymer is a homopolymer or copolymer of a 3,4-dialkoxythiophene selected from the group consisting of poly(3,4-methylenedioxythiophene), poly(3,4-methylenedioxythiophene) derivatives, poly(3,4-ethylenedioxythiophene), poly(3,4-ethylenedioxythiophene) derivatives, poly(3,4-propylenedioxythiophene), poly(3,4-propylenedioxythiophene) derivatives, poly(3,4-butylenedioxythiophene), poly(3,4-butylenedioxythiophene) derivatives, and copolymers therewith. The polyanionic compound is then preferably poly(styrene sulfonate).

The thickness of the electrochemically active polymer layer is preferably larger than a monolayer (>0.5 nm). The thickness of the electrochemically active polymer layer may preferably be in the range of 1-300 nm, such as in the range of 50-250 nm or in the range of 50-150 nm.

The ferroelectric layer of the electrochemical device may comprise an organic, inorganic or organic-inorganic ferroelectric material. The ferroelectric layer may consist of a single ferroelectric material or a mixture of two or more ferroelectric materials. Optionally, the ferroelectric layer may further comprise non-ferroelectric additives, for example a non-ferroelectric dielectric.

Examples of inorganic ferroelectric materials, which could be employed in the ferroelectric layer include, but are not limited to antimony sulfoiodide, barium titanate, colemanite, europium barium titanate, germanium telluride, lead scandium tantalate, lead titanate, lead zirconate titanate, lithium niobate, potassium dihydrogen phosphate, potassium titanyl phosphate, and sodium nitrite.

According to an embodiment, the ferroelectric material of the electrochemical device is an organic ferroelectric material. Organic ferroelectric materials may comprise molecular, macromolecular, oligomeric or polymeric ferroelectric materials.

Examples of organic ferroelectric materials, which could be employed in the ferroelectric layer include, but are not limited to ferroelectric polymers, potassium sodium tartrate, benzimidazoles, thiourea, TEMPO (2,2,6,6-tetramethyl-1-piperidinyloxy), CDA (cyclohexan-1,1'-diacetic acid), TCAA (trichloroacetamide), Benzil, DNP (1,6-bis(2,4-dinitrophenoxy)-2,4-hexadiyne), TCHM (tricyclohexylmethanol), VDF oligomer, CT complexes such as TTF-CA and TTF-BA, Phz-$H_2$ca, Phz-$H_2$ba, [H-55dmbp][Hia], and $\beta$-quinol-methanol clathrate.

Ferroelectric polymers that may be used in the invention include, but are not limited to, polyvinylidene fluoride (PVDF) and its copolymers with trifluoroethylene (P(VDF-TrFE)), terpolymers based on either copolymers or P(VDF-TrFE), other ferroelectric polymers such as odd-numbered nylons, such as nylon-11 or cyanopolymers.

Examples of organic-inorganic ferroelectric compounds that may be used in the invention include, but are not limited to, HdabcoReO$_4$ (dabco = diazabicyclo[2.2.2]octane), TGS (triglycine sulphate), TSCC (Tris-sarcosine calcium chloride) and Rochelle salt.

According to an embodiment, the ferroelectric layer consists of a P(VDF-TrFE) copolymer. In addition to having good ferroelectric properties, these polymers also have excellent dielectric properties. The ratio of VDF to TrFE monomer in the P(VDF-TrFE) copolymer may be in the range of 90/10 to 10/90, preferably in the range of 90/10 to 50/50, or more preferably in the range of 80/20 to 60/40, such as about 75/25, 70/30 or 65/35.

The thickness of the ferroelectric layer is preferably larger than 10 nm. The thickness of the ferroelectric layer may for example be in the range of 10-1000 nm. The thickness of the ferroelectric layer may typically be in the range of 20-400 nm, such as in the range of 60-200 nm, such as about 140 nm. The thickness of the ferroelectric layer may preferably be kept low, e.g. below 200 nm since thicker layers may require higher switching (polarization) voltages. A thickness above 60 nm may be preferred, since lower thickness may lead to unstable performance in terms of remanent polarization characteristics, but ferroelectric layers having a thickness of less than 60 nm may also be acceptable depending on the device structure. For example, in a device comprising a polymeric interlayer between the ferroelectric layer and the gate electrode, the thickness of the ferroelectric layer may be less than 60 nm.

It is preferred that the surface charge of the ferroelectric layer in contact with the ion conductor layer is sufficiently large in relation to the total bulk charge of the electrochemically active layer, such that polarization of the ferroelectric layer will generate a sufficient amount of charges to switch the electrochemically active layer to a different electronic state. The surface charge of the ferroelectric layer will only exhibis small variations with the ferroelectric layer thickness, particularly in the preferred thickness range of 60-200 nm, whereas the bulk charge of the electrochemically active layer, being a bulk property, will be dictated by the thickness (or volume) of the electrochemically active layer.

Thus, in some embodiments the ratio between the ferroelectric layer surface charge and the electrochemically active layer bulk charge is at least 1:1, preferably larger than 1:1, larger than 2:1, larger than 4:1, larger than 8:1, or larger than 10:1. In a preferred embodiment, the ratio between the ferroelectric layer surface charge and the electrochemically active layer bulk charge is larger than 1:1.

In order to achieve the desired ratio between the ferroelectric layer surface charge and the electrochemically active layer bulk charge, size and the geometry, of the electrochemically active layer can be adjusted. For example, the total volume of the electrochemically active layer can be reduced, and/or the total surface area of the ferroelectric layer in contact with the ion conductor layer can be increased.

In order to obtain a sufficient amount of ion migration in the ion conductor layer upon polarization of the ferroelectric layer to switch the electrochemically active layer to a different electronic state, it may sometimes be necessary to have a ferroelectric layer:electrochemically active layer area ratio larger than 1:1. This means that the surface area of the ferroelectric layer in contact with the ion conductor layer is larger than the surface area of the electrochemically active layer in contact with the ion conductor layer. This way the amount of ion migration generated in the ion conductor layer and introduced into the electrochemically active layer upon polarization of the ferroelectric layer can be increased.

As an example, as the typical bulk charge density of PEDOT:PSS may be about 100-150 $\mu$C cm$^{-2}$, a P(VDF-TrFE):PEDOT area ratio larger than 10:1 may be used to switch the PEDOT:PSS bulk in between the different electronic states.

In some embodiments, a ferroelectric layer:electrochemically active layer area ratio larger than 1:1 may be used. In some embodiments, the ferroelectric layer:electrochemically active layer area ratio is larger than 1:1, larger than 2:1, larger than 4:1, larger than 8:1, or larger than 10:1.

According to an embodiment, the electrochemically active polymer, the ferroelectric and/or the ion conductor comprise organic materials. According to a preferred embodiment, the electrochemically active polymer, the ferroelectric and the ion conductor all comprise organic materials. One advantage of using organic materials in the electrochemical device is that it may allow of manufacturing flexible electronic devices. A further advantage of using organic materials in the device is that such organic materials are generally suitable for being applied to a substrate using liquid deposition techniques. Preferably, at least one of the electrochemically active polymer, the ferroelectric and/or the ion conductor may be applied by liquid deposition techniques. According to an embodiment, the electrochemically active polymer, the ferroelectric and/or the ion conductor can be applied by liquid deposition techniques. According to a preferred embodiment, the electrochemically active polymer, the ferroelectric and the ion conductor can all be applied by liquid deposition techniques.

In an electrochromic pixel as illustrated in Figure 1, comprising PEDOT:PSS as the electrochemically active polymer layer, by applying a voltage, the ferroelectric layer gets fully polarized and a charge spatial distribution at the ferroelectric /ion conductor interface is established. The ions in the ion conductor are disassociated and migrate to the ferroelectric layer and to the PEDOT:PSS layer along the electric field. Electrochemical reaction occurs in the PEDOT:PSS electrode only after the voltage applied to the ferroelectric counter electrode overcomes a certain threshold voltage which is necessary to flip the dipoles within the ferroelectric layer.

To prevent migration of ions from the ion conductor layer into the ferroelectric layer of the electrochemical device may further comprise a metal interlayer arranged between the ion conductor layer and the ferroelectric layer, separating the two layers form each other.

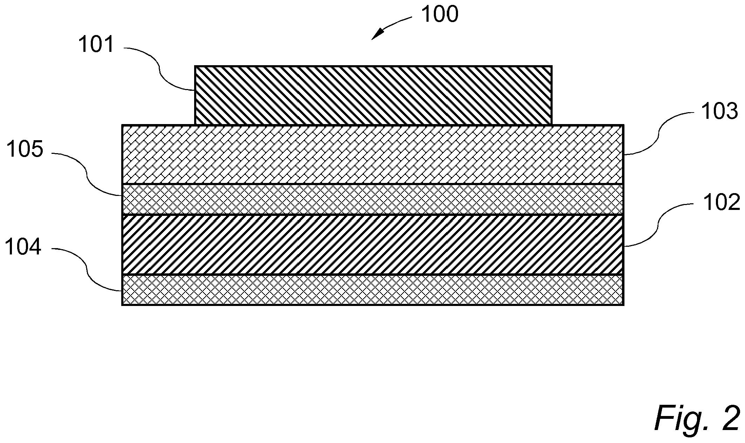

Figure 2 schematically shows one embodiment of an electrochemical pixel. The device of Figure 2 corresponds to the device of Figure 1, further comprising a metal interlayer 105 arranged between the ion conductor layer 103 and the ferroelectric layer 102.

The metal interlayer may for example comprise a metal selected from the group consisting of chromium, titanium, copper, aluminium, molybdenum, tungsten, nickel, gold, palladium, platinum, and combinations thereof.

The thickness of the metal interlayer is preferably sufficient to prevent migration of ions from the ion conductor layer into the ferroelectric layer of the electrochemical device. Preferably, the thickness of the metal interlayer is in the range 30 nm to 500 nm.

The layers of the devices shown in Figures 1 and 2 may be provided in the order shown in the Figures, i.e. electrode - ferroelectric layer - ion conductor layer - electrochemically active layer, or in the reverse order, i.e. electrochemically active layer - ion conductor layer - ferroelectric layer - electrode. The devices can be provided on a substrate, e.g. a plastic film, and may also be covered by another substrate, e.g. a plastic film.

When the electrode or metal interlayer, is deposited onto the ferroelectric layer, there is a danger of damaging the ferroelectric layer. To reduce the risk of damaging the ferroelectric layer a polymeric interlayer may be applied between the ferroelectric layer and the electrode or metal interlayer. This allows a wider selection of electrode deposition and patterning processes and electrode materials. A polymeric interlayer can also prevent diffusion of metal from a metal electrode into the ferroelectric layer, thereby reducing the leakage current, and improve the printability when an aqueous-based polymeric electrode is applied.

The polymer of the polymeric interlayer, which may for example comprise a polyelectrolyte, protects the thin ferroelectric layer from damage when the electrode or metal interlayer is applied and may also provide improved adhesion between the ferroelectric layer and the electrode or metal interlayer.

The material of polymeric interlayer may be selected among the same materials as the ion conductor layer. According to an embodiment, the materials of polymeric interlayer and the ion conductor layer are the same.

Typically the polymeric interlayer comprises a polyelectrolyte. The polymeric interlayer may for example consist of a homopolymer or copolymer bearing phosphonic or phosphoric acid groups and optional other functional groups, or a blend thereof. An example of a polymeric interlayer material useful in a an electrochemical device according to the invention is a co-polymer of vinylphosphonic acid (VPA) and acrylic acid (AA), such as co-polymer P(VPA-co-AA)(70:30).

Such materials display low complex impedance, even under anhydrous conditions and at higher temperatures, e.g. at 80 °C. It also exhibits high dielectric constants (300-500) in the frequency range 10 kHz to 100 kHz.

The thickness of the polymeric interlayer may for example be in the range of 1-1000 nm. The thickness of the polymeric interlayer is preferably larger than 10 nm. The thickness of the polymeric interlayer may typically be in the range of 20-200 nm, such as in the range of 40-100 nm or in the range of 40-80 nm.

According to an embodiment, the electrochemical device is an electrochemical transistor. The electrochemical transistor preferably comprises at least three electrodes, a source electrode arranged in electronic contact with the said electrochemically active layer, a drain electrode arranged in electronic contact with the said electrochemically active layer, and a gate electrode arranged for tuning the conductivity of the electrochemically active layer.

The source and drain electrodes are arranged in electronic contact with the electrochemically active polymer layer and the gate electrode is separated from the electrochemically active polymer layer by the ferroelectric layer and ion conductor layer. According to an embodiment, the transistor channel of the electrochemical transistor device is formed of the electrochemically active polymer layer located between a source and a drain electrode. The conductivity of the transistor channel is altered or controlled by changing the oxidation state of the electrochemically active polymer layer. This may be achieved by changing the voltage applied to the gate electrode, whereby ferroelectric polarization of the ferroelectric layer is achieved. The polarization of the ferroelectric layer in turn causes the ions in the ion conductor layer to be redistributed.

As used herein, the expression that two materials are 'in electronic contact' means that an exchange of electrons is enabled between the two materials. The electrochemically active layer, or a portion thereof, forms the transistor channel, through which electrons can travel between the source and drain electrodes when the electrochemically active layer is in a conductive state. Hence, in the context of this disclosure it also means that if the organic electrochemically active material is in a conducting state, and a voltage is applied to said source electrode and said drain electrode, a current will flow through said electrochemically active material, across the transistor channel, from said source to said drain electrode.

Generally, it is not necessary that the gate electrode is arranged such that it faces said source and drain electrodes. In other words, the gate electrode may be laterally displaced along the surface of said electrolyte layer, with respect to said source and drain electrodes.

Said source, drain and gate electrodes are preferably each arranged of a different material compared to said electrochemically active layer. The electrodes may generally consist of materials having high electrical conductivity.

Advantageously, said source electrode and/or said drain electrode and/or said gate electrode comprises a material selected from the group consisting of chromium, titanium, copper, aluminium, molybdenum, tungsten, nickel, gold, palladium, platinum, conducting polymers and oligomers, carbon paste, carbon nanotubes, silver paste and combination thereof. In applications where a fully organic device is desired, e.g. to facilitate disposal/recycling, the electrodes may consist of conducting polymers and oligomers.

Preferably, the thickness of the said source and drain electrodes is in the range 30 nm to 500 nm.

Figure 3 schematically shows one embodiment of an electrochemical transistor 300 according to the invention. The electrochemical transistor device of Figure 3 is arranged in a so called bottom gate configuration. The transistor is arranged on a substrate (not shown). A ferroelectric layer 302 is arranged between said electrochemically active 301 layer and a gate electrode 304. The ferroelectric layer is arranged such that polarization of the ferroelectric material can be altered by changing the voltage applied to the gate electrode 304. The transistor further comprises an ion conductor layer 303 arranged between said electrochemically active layer 301 and said ferroelectric layer 302. The transistor comprises a source electrode 306a and a drain electrode 306b, which are both in electronic contact with an electrochemically active layer 301. The source and drain electrodes may be applied directly onto the electrochemically active layer 301. Alternatively, as shown in the Figure, the source and drain electrodes may be separated from the ion conductor layer 303 by an electrical insulator layer 310, preventing direct electronic contact between the source and drain electrodes and the ion conductor layer. The electrochemically active layer is arranged such that its conducting properties can be varied, e.g. by altering its oxidation state. Hence, when a voltage is applied between the source electrode and the drain electrode, the size of the current through the transistor channel, between said source and drain electrodes can be controlled by controlling the oxidation state of the electrochemically active layer.

The conductivity of the transistor channel is altered or controlled by changing the oxidation state of the electrochemically active material. This altered oxidation state may be achieved by changing the voltage applied to the gate electrode, whereby ferroelectric polarization of the ferroelectric layer is achieved. The polarization of the ferroelectric layer in turn causes ions in the ion conductor layer to be redistributed. Ions from the ion conductor layer migrate into the electrochemically active layer, causing a change of the oxidation state of the electrochemically active material. The transistor channel opens when the electrochemically active material is in a conductive oxidation state.

Ideally, the current between said source and drain electrodes is zero when there is no electric field applied across said ion conductor. Moreover, ideally there is no electronic contact, i.e. no leakage current, between said gate electrode and any of said source or drain electrodes.

For an electrochemical transistor (ECT) as illustrated in Figure 3, comprising PEDOT:PSS as the electrochemically active polymer layer, by applying a voltage, the ferroelectric layer gets fully polarized and a charge spatial distribution at ferroelectric /ion conductor interface is established. The ions in the ion conductor are disassociated and migrate to the ferroelectric layer and to the PEDOT:PSS layer along the electric field. Electrochemical reaction occurs in the PEDOT:PSS electrode only after the voltage applied to the ferroelectric counter electrode overcomes a certain threshold voltage which is necessary to flip the dipoles within the ferroelectric layer. The redox reactions in PEDOT:PSS define two different conductive state, the "on" state and the "off" state, respectively, with a typical hysteretic behavior of the I-V characteristics.

To prevent migration of ions from the ion conductor layer into the ferroelectric layer of the electrochemical device may further comprise a metal interlayer arranged between the ion conductor layer and the ferroelectric layer, separating the two layers form each other.

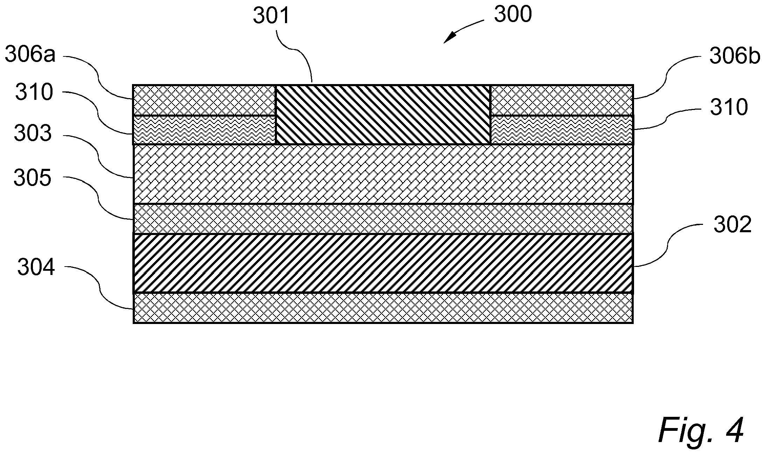

Figure 4 schematically shows one embodiment of an electrochemical transistor. The transistor of Figure 4 corresponds to the transistor of Figure 3, further comprising a metal interlayer 305 arranged between the ion conductor layer 303 and the ferroelectric layer 302.

The metal interlayer may for example comprise a metal selected from the group consisting of chromium, titanium, copper, aluminium, molybdenum, tungsten, nickel, gold, palladium, platinum, and combinations thereof.

The thickness of the metal interlayer is preferably sufficient to prevent migration of ions from the ion conductor layer into the ferroelectric layer of the electrochemical device. Preferably, the thickness of the metal interlayer is in the range 30 nm to 500 nm.

When the layers of the devices shown in Figures 3 and 4 are deposited in the reverse order, i.e. electrochemically active layer - ion conductor layer - ferroelectric layer - electrode, there is a danger of damaging the ferroelectric layer. To reduce the risk of damaging the ferroelectric layer a polymeric interlayer may be applied between the ferroelectric layer and the gate electrode. This allows a wider selection of electrode deposition and patterning processes and electrode materials. A polymeric interlayer can also prevent diffusion of metal from a metal gate electrode into the ferroelectric layer, thereby reducing the leakage current, and improve the printability when an aqueous-based polymeric electrode is applied.

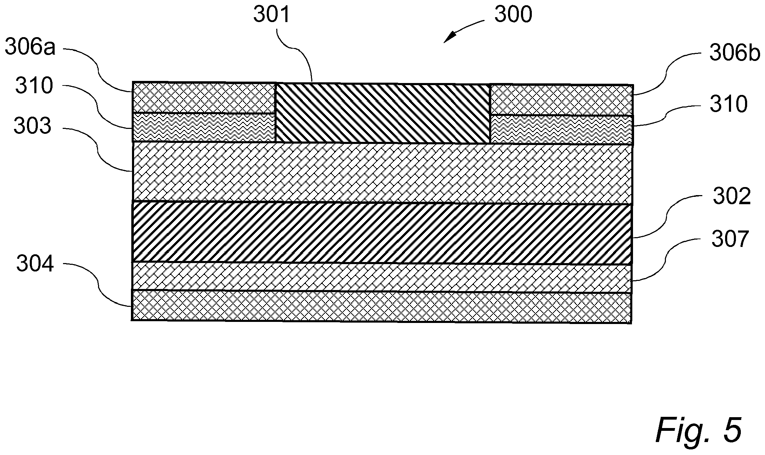

Figure 5 schematically shows one embodiment of an electrochemical transistor. The transistor of Figure 5 corresponds to the transistor of Figure 3, further comprising a polymeric interlayer 307 arranged between said gate electrode 304 and said ferroelectric layer 302. The polymer of the polymeric interlayer, which may for example comprise a polyelectrolyte, protects the thin ferroelectric layer from damage when the gate electrode is applied and may also provide improved adhesion between the ferroelectric layer and the gate electrode.

The material of polymeric interlayer may be selected among the same materials as the ion conductor layer. According to an embodiment, the materials of polymeric interlayer and the ion conductor layer are the same.

Typically the polymeric interlayer comprises a polyelectrolyte. The polymeric interlayer may for example consist of a homopolymer or copolymer bearing phosphonic or phosphoric acid groups and optional other functional groups, or a blend thereof. An example of a polymeric interlayer material useful in a an electrochemical transistor according to the invention is a co-polymer of vinylphosphonic acid (VPA) and acrylic acid (AA), such as co-polymer P(VPA-co-AA)(70:30). Such materials display low complex impedance, even under anhydrous conditions and at higher temperatures, e.g. at 80 °C. It also exhibits high dielectric constants (300-500) in the frequency range 10 kHz to 100 kHz.

The thickness of the polymeric interlayer may for example be in the range of 1-1000 nm. The thickness of the polymeric interlayer is preferably larger than 10 nm. The thickness of the polymeric interlayer may typically be in the range of 20-200 nm, such as in the range of 40-100 nm or in the range of 40-80 nm.

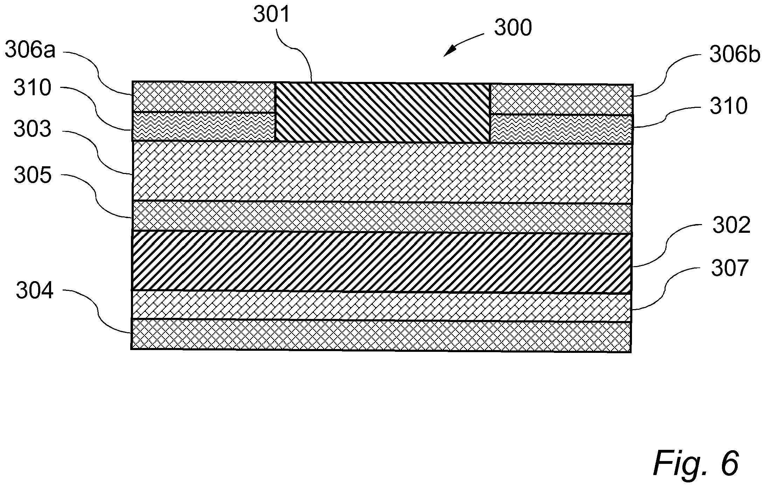

Figure 6 schematically shows one embodiment of an electrochemical transistor. The transistor of Figure 6 corresponds to the transistor of Figure 3, further comprising a metal interlayer 305 as described with reference to Figure 4, arranged between the ion conductor layer 303 and the ferroelectric layer 302, and a polymeric interlayer 307 as described with reference to Figure 5, arranged between said gate electrode 304 and said ferroelectric layer 302.

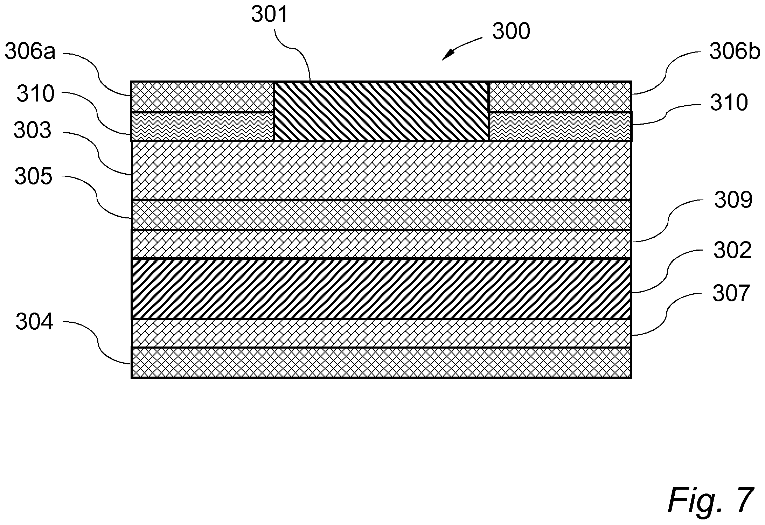

Figure 7 schematically shows one embodiment of an electrochemical transistor. The transistor of Figure 7 corresponds to the transistor of Figure 6, further comprising a second polymeric interlayer 309 arranged between the ferroelectric layer 302 and the metal interlayer 305. The polymer of the second polymeric interlayer 309, which may for example comprise a polyelectrolyte, protects the thin ferroelectric layer 302 from damage when the metal interlayer 305 is applied and may also provide improved adhesion between the ferroelectric layer and the metal interlayer. The material of second polymeric interlayer 309 may be selected among the same materials as the polymeric interlayer 307. The thickness of the second polymeric interlayer may for example be in the range of 1-1000 nm. The thickness of the second polymeric interlayer is preferably larger than 10 nm. The thickness of the second polymeric interlayer may typically be in the range of 20-200 nm, such as in the range of 40-100 nm or in the range of 40-80 nm.

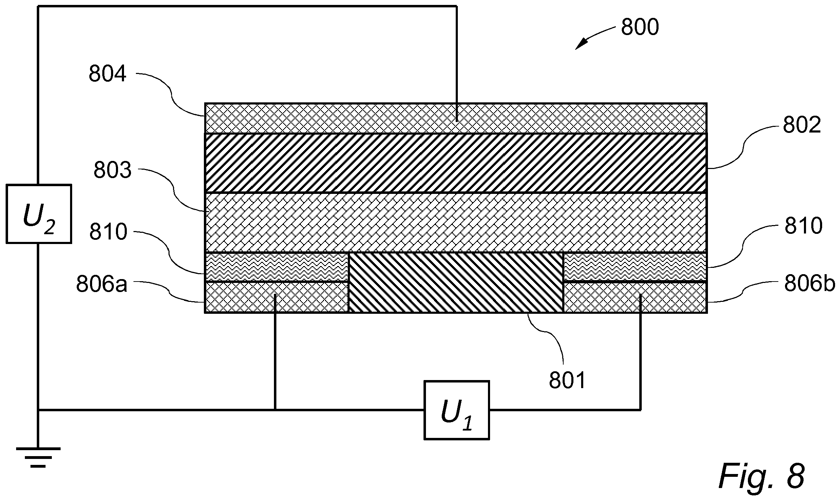

Figure 8 schematically shows one embodiment of an electrochemical transistor according to the invention. The electrochemical transistor device of Figure 8 is arranged in a so called top gate configuration. The transistor comprises a source electrode 806a and a drain electrode 806b arranged on a substrate (not shown). The source electrode 806a and a drain electrode 806b are both in electronic contact with an electrochemically active layer 801. An ion conductor layer 803 is applied over the electrochemically active layer 801. The source and drain electrodes are separated from the ion conductor layer 803 by an electrical insulator layer 810, preventing direct electronic contact between the source and drain electrodes and the ion conductor layer. A ferroelectric layer 802 is applied over the ion conductor layer 803. A gate electrode 804 is applied over the ferroelectric layer 802 such that the polarization of the ferroelectric material can be altered by changing the voltage applied to the gate electrode, and such that the ion conductor layer is separated from the gate electrode by the ferroelectric layer. The electrochemically active layer is separated from the gate electrode by the ion conductor layer and the ferroelectric layer. The electrochemically active layer is arranged such that its conducting properties can be varied, e.g. by altering its oxidation state. Hence, when a voltage is applied between the source electrode and the drain electrode, the size of the current through the transistor channel, between said source and drain electrodes can be controlled by controlling the oxidation state of the electrochemically active layer.

According to an embodiment (not shown) the transistor of Figure 8 may further comprise a metal interlayer arranged between the ion conductor layer and the ferroelectric layer. The material and thickness of the metal interlayer would correspond to the materials and thicknesses described above with reference to the metal interlayer of Figure 4.

According to an embodiment (not shown) the transistor of Figure 8 may further comprise a polymeric interlayer arranged between the gate electrode and the ferroelectric layer. The material and thickness of such polymeric interlayer would correspond to the materials and thicknesses described above with reference to the polymeric interlayer of Figure 5. Having a polymeric interlayer in the transistor can smooth the metal surface and improve the metal/ferroelectric interface.

Typically, gate control voltage or the voltage difference between said source and gate electrode is between -20 V to +20 V, preferably between -10 V to +10 V. The required voltage depends for example on the thickness of the ferroelectric layer.

The operation and properties of embodiments of the electrochemical devices as described herein will be further illustrated by the examples. In the above embodiments, the inventors have shown that an ion conductor can be used for significantly improving the properties of electrochemical pixels and transistors. Such pixels and transistors have clear applications, e.g., in non-volatile memory devices, as well as in large transistor-to-transistor logic networks, radio-frequency identification technologies and matrixed organic light-emitting diode displays.

Some of the advantages of the inventive electrochemical devices include:

1) Electrical addressing and re-programming
2) Multi-bit storage per memory cell
3) Non-volatility of years (> 5 years)
4) Low-voltage operation (< 10 V) and low-voltage non-destructive read-out (1 V)
5) Printability on flexible substrates.

While the invention has been described with reference to various exemplary embodiments, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims. Particularly, a person skilled in the art will in the light of the present disclosure be able to select suitable electrode materials, electrochemically active materials, ferroelectric materials and ion conductor materials. Further, a man skilled in the art understands that the electrochemical device can be manufactured by e.g. screen printing, flexo printing, ink-jet printing, gravure printing, offset printing, spin coating, evaporation, chemical vapor deposition, electrodeposition, and electroless plating.

EXAMPLES

Example 1 - Fabrication of P(VDF-TrFE) Films

Ferroelectric P(VDF-TrFE) 70/30 mol % copolymer (Solvay SA) was dissolved in diethyl carbonate (DEC) at a concentration of 4 wt% and filtered through a 0.45 $\mu$m filter.

An Au bottom electrode was deposited on Si substrate via thermal evaporation. The prepared P(VDF-TrFE) solution was spin coated on the bottom electrode with 2000 rpm spin rate for 30 s and annealed in 130 °C for 20 minutes to obtain a 140 nm thick film. In order to deposit thicker films the spin coating step may be repeated a number of times (according to the desired thickness). For the devices with a metal interlayer, an aluminum layer was also deposited via thermal evaporation.

Example 2 - Preparation of Bistable PEDOT:PSS Pixels

A plastic foil of polyethylene terephthalate (PET) with a thin poly(3,4-ethylenedioxythiophene):poly(styrenesulfonate) (PEDOT:PSS) layer on top was used as substrate (AGFA-Gevaert Orgacon F-350). The substrate was rinsed in acetone, deionized water and isopropanol, and baked at 110 °C for 10 min. Shipley s1805 photoresist was then spin coated onto the surface. The substrate was exposed with a mask aligner (Suss MA/BA 6) and developed in Microposit MF319. After a baking step at 110 °C for 10 min, the pattern was dry-etched using O2/CF4 plasma. The remaining photoresist was removed with Shipley 1112A and the substrate was rinsed in acetone and deionized water. The pixel size was 500 by 500 $\mu m^2$. The electrolyte Luviquat (purchased from BASF) was placed on top of the prepared P(VDF-TrFE) film and the patterned PEDOT:PSS pixels are laminated on the electrolyte and pressed to get a thickness of a few millimeters. In the devices with the interlayer, a layer of aluminum was deposited on top of the P(VDF-TrFE) film before the electrolyte is applied.

Example 3 - Bistable Electrochemical Transistors

Source, drain and channel active materials of the transistors were screen printed on PET plastic foils. The source and drain electrodes consisted of a carbon conductive composition (DuPont 7102). The channel (100 $\mu m$ in length), which connects the source with the drain electrodes, was made of PEDOT:PSS. An insulator layer was screen printed on top of source, drain and PEDOT:PSS channel. An opening in the insulator permits the gate to come in contact with the channel thorough an electrolyte. Bistability was induced in the organic electrochemical transistor by connecting the gate of the transistor to a P(VDF-TrFE) capacitor. A top aluminum layer was deposited on top of the prepared P(VDF-TrFE) film to obtain a P(VDF-TrFE) capacitor. The capacitor was connected to the gate of the OECT via external wiring or by lamination.

Example 4 - Electrical Measurements and Imaging

Charge displacement measurements were performed using a Sawyer Tower circuit with an Agilent function generator connected to the input and the Oscilloscope recording the output. The other electrical characteristics of the devices were measured using a semiconductor parameter analyzer (Keithley 4200-SCS).

For recording the electrochromism of the PEDOT:PSS pixels, a video was captured using a Nikon SMZ1500 via a microscope while the input was applied to the pixels by the parameter analyzer. The images were extracted from the video and enhanced using a MATLAB® code to clarify the contrast between the on and off pixels.

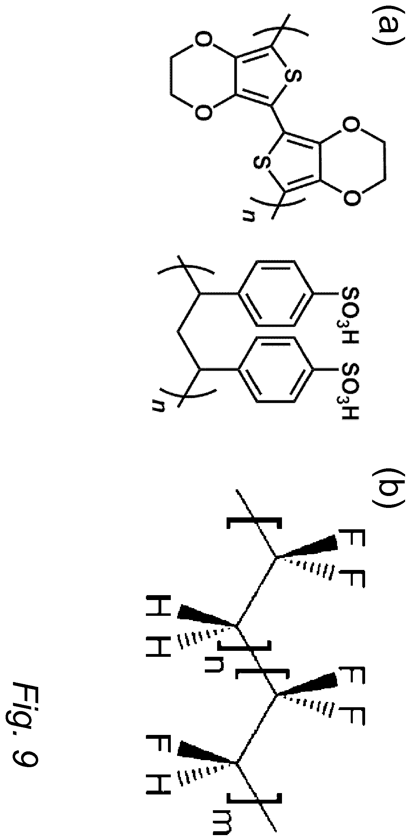

One of the most promising and explored materials for electrochemical devices is the solution-processable poly(3,4-ethylenedioxythiophene):poly(styrenesulfonate) (PEDOT:PSS). The molecular structure is shown in Figure 9a. PEDOT:PSS is a widely used conducting polymer which exhibits a high in-plane conductivity of around $10^3$ S cm$^{-1}$ thanks to the p-type doping of PEDOT provided by the PSS phase. The conductivity of this polymer can be modulated via exchange of ions, provided from an electrolyte and driven by the potential of a counter electrode, with the PSS phase and charge compensation occurring in the PEDOT phase. In an electrochemical cell, PEDOT:PSS can be switched to its deep blue, semiconducting neutral state, in accordance with the following (1):

$$PEDOT^+:PSS^- + M^+ + e^- \rightarrow PEDOT^0 + M^+:PSS^- \qquad (1)$$

where $M^+$ denotes the positively charged ion and $e^-$ the electron. Hence, the change in electrical conductivity upon electrochemical switching can be exploited in electrochemical transistors, while the modulation in optical absorption is used in electrochemical pixels.

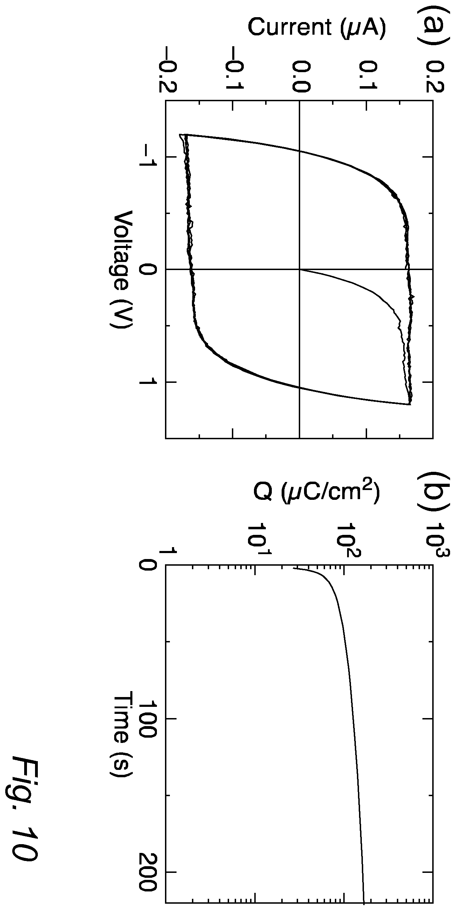

Nevertheless, when PEDOT:PSS is used as both the working and the counter electrodes in electrochemical cells (i.e. a pixel), in contact with a common electrolyte, the degree of ion exchange and charge compensation as well as the pixel coloration occurs linearly throughout the whole addressing potential bias window due to the typical capacitive charging behavior of PEDOT:PSS, see Figure 9. The typical current versus voltage (*I-V*) characteristics of a pixel is then governed by the capacitive charging and discharging of the electrodes with a consequence lack of any threshold or rectification behavior that would make passive matrix addressing possible (Fig. 10a). The typical bulk charge density of the PEDOT:PSS film with a thickness of d = 100-200 nm is about 100-300 $\mu C$ cm$^{-1}$ (Fig. 10b).

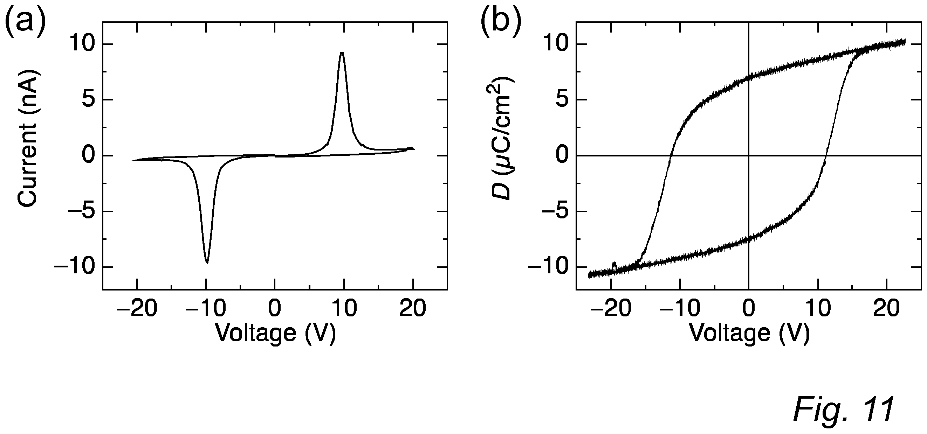

The ferroelectric fluorinated polymer poly(vinylidenefluoride-co-trifluoroethylene) (P(VDF-TrFE) (see Figure 9b), can maintain an electric polarization state in the absence of an externally applied electric field. The polarization state and the resulting surface charge density originate from a bistable, switchable dipole moment, maintained across the ferroelectric domains of the material. Figure 11a shows the typical *I-V* characteristic for a capacitor with a 140-$\mu m$-thick P(VDF-TrFE) ferroelectric layer. The current peaks located at around ±9-10 V are due to the ferroelectric polarization (coercive field of about 70 MV m$^{-1}$). The net surface charge density can be induced to be either positive or negative depending on the direction of the applied polarizing electric field. Dielectric displacement measurements performed at 100 Hz yield a remanent polarization of about 8-10 $\mu$C cm$^{-1}$ (Figure 11b).

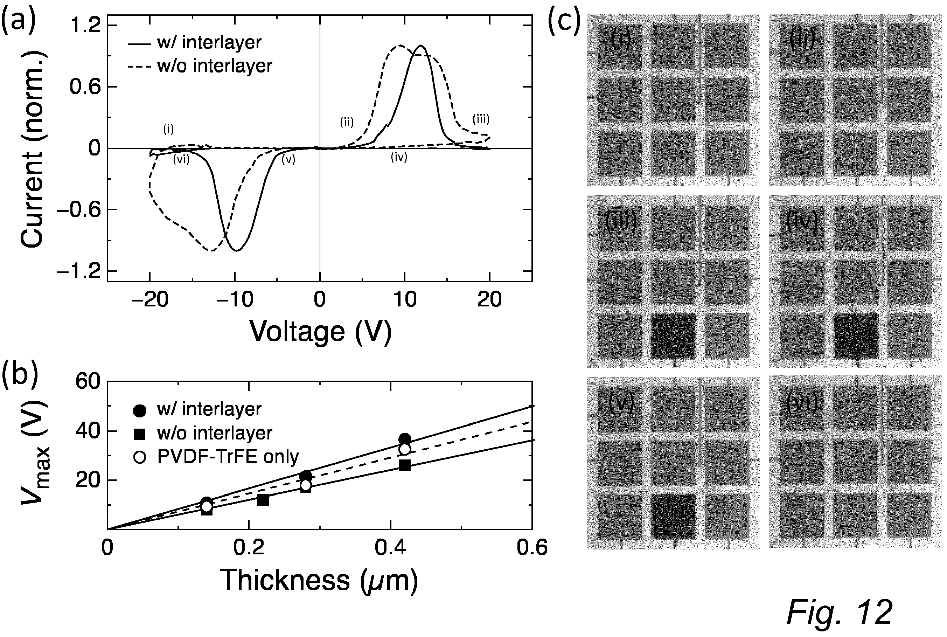

In the electrochemical pixel prepared according to Example 2, using ferroelectric P(VDF-TrFE) thin film deposited onto a bottom metal substrate as counter electrode, a rather different behavior of the PEDOT pixel *I-V* characteristics is observed (Figure 12a and 12c). At positive voltage bias, where the pixel switches from the conducting light blue-colored state to the semiconducting dark blue-colored state, a fairly small current is observed until the applied potential reaches above the coercive voltage, defined as the minimum voltage bias required to fully switch the remanent ferroelectric polarization of dipoles. Because of the high ferroelectric surface charge density, which is typically on the order of 8-10 $\mu$C cm$^{-2}$ for P(VDF-TrFE) films (as shown in Figure 11b), an electric double layer (EDL) is established at the ferroelectric/electrolyte interface, while the ferroelectric polarization charge is compensated by free charges at the bottom metal electrode. The polarization switching time is not limited nor affected by the polyelectrolyte interlayer. Furthermore, recent studies have shown that dipolar interactions identified as Coulomb attractions between hydrogen atoms in the PVDF chains and anions promote switching of ferroelectric polarization. In this respect, polyelectrolytes, ionic liquids and polymer electrolytes containing various kinds of electrolyte components can supply enough of charges needed for a full compensation of the sheet of ferroelectric dipoles in order to stabilize the domains during the switching process. As the typical bulk charge density of a 100-nm-thick PEDOT:PSS film is about 100-150 $\mu$C cm$^{-2}$, a PEDOT:P(VDF-TrFE) area ratio larger that 1:10 is used to switch the PEDOT:PSS bulk in between the different electronic states given by (1). When the ferroelectric polymer is poled by a positive bias voltage applied to the bottom electrode that is high enough to flip the dipoles, a displacement current is established through the ferroelectric layer resulting in a rapid increase of the current level. The PEDOT$^+$ then starts to be chemically reduced to PEDOT$^0$ (dark blue state). The reduction of PEDOT$^+$ continues with an increasing current until the majority of chains turn neutral (PEDOT$^0$). The process saturates at a voltage of around 12 V, which corresponds to the expected coercive voltage for a ferroelectric layer thickness of about 220 nm. At even higher positive voltages a permanent decrease in film conductivity is observed, thus PEDOT is now in its non-conducting neutral state. The dark blue-colored state of PEDOT$^0$ is maintained until the ferroelectric dipoles are switched back in the opposite direction upon application of a negative potential to the bottom electrode (Figure 12b). In order to avoid or reduce leakage currents a metal interlayer was included between the PVDF film and the electrolyte. The metal interlayer does not affect the properties of the ferroelectric film and thus not the resulting performance of the device, but it protects the ferroelectric from any influx of ions. Figure 12a shows the I-V characteristics of the PEDOT:PSS pixel comprising the metal interlayer. The voltage required to switch the ferroelectric polarization can be controlled, without any loss of the ferroelectric surface charge density, by increasing/decreasing the ferroelectric layer thickness. Figure 12b shows the current peak voltage values as a function of the P(VDF-TrFE) film thickness. A nearly perfect linear correlation was found regardless of the inclusion of the metal interlayer or not, with voltage levels similar to those found in P(VDF-TrFE) capacitor devices (open symbols).

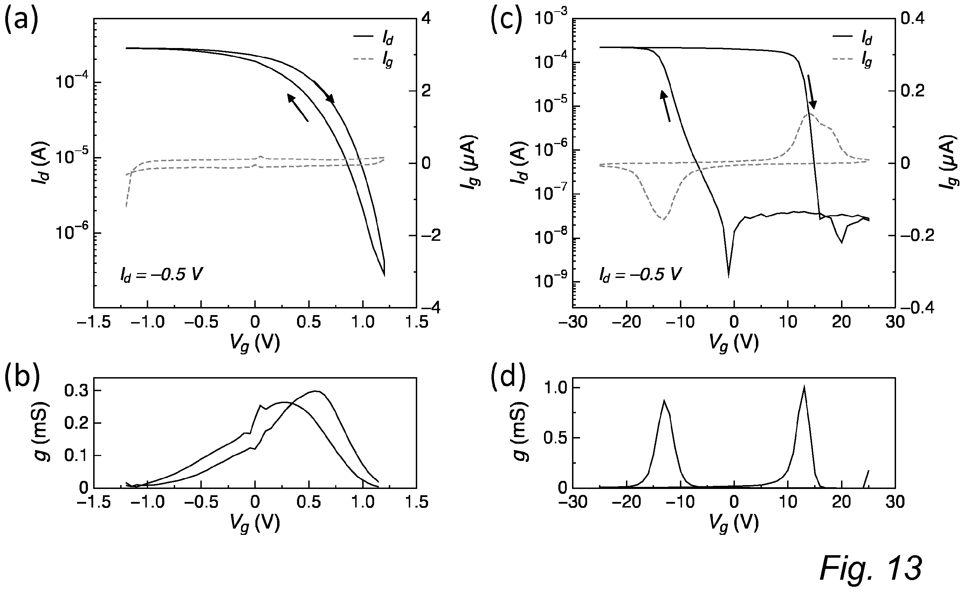

The hysteric switching, achieved using a ferroelectric polymer counter electrode, of the electronic states in PEDOT is also reflected in a threshold switching of the resistive state. The modulation of the in-plane conductivity is characterized using a three-terminal device, i.e. the electrochemical transistor (ECT) prepared according to Example 3. The operation of a PEDOT-based ECT relies on the reversible ion exchange and charge compensation switching of the PEDOT:PSS channel that modulates the electronic conductivity between the source and the drain contact. This doping and de-doping of PEDOT can result in conductivity changes of several orders of magnitude with consequent modulation of drain-source current ($I_D$). Figure 13 demonstrates an ECT where the conducting PEDOT:PSS polymer system was printed on a flexible plastic substrate. In typical PEDOT-based ECTs, the drain current decreases with gate voltage, consistent with operation in the depletion regime (see Figure 13a). When a positive bias is applied at the gate, cations from the electrolyte enter the PEDOT:PSS film and compensate the pendant sulphonate anions along the PSS polyanion. This leads to a decrease of the hole density in the PEDOT phase, as holes extracted at the drain are not re-injected by the source terminal. This then results in a decrease of the drain current, see Figure 13b, with an associated transconductance, defined as g = d$I_d$/d$I_g$, reaching a maximum of about 0.3 mS at $V_G$ ranging from 0.25 to 0.6 V. When the ferroelectric layer is included in the gate configuration, the displacement current of the ferroelectric layer, provided from switching of ferroelectric dipoles, dictates the gate current of the resulting ECT. Therefore, the thickness of the ferroelectric layer determines the coercive voltage and consequently the modulation of the current of the channel. Upon varying the gate voltage, the conductivity of the channel is constant until the coercive field of the ferroelectric material is reached (see Figure 13c). As soon as the coercive voltage is overcome the dipole displacement current, of the ferroelectric, flows through the gate. This decreases (high resistive state, low current) or increases (low resistive state, high current) the number of charge carriers of the PEDOT channel. The accompanying current switching is observed as sharp features in the gate current at $\pm 14$ V (the P(VDF-TrFE) film thickness is ca. 280 nm), and as steep increase and decrease of the drain current, depending on the switching direction of the ferroelectric dipoles. The characteristic performance of the ECT, which includes the ferroelectric layer gate configuration, confirms that the memory effect is driven by ferroelectric polarization switching, rather than any charge trapping mechanisms or ion migration in and through the ferroelectric layer. Hence, the transistor behaves as a bi-stable memory cell element. Accordingly, the transconductance peaks just at $V_G$ bias levels where the ferroelectric layer is being poled while it is negligible at the $V_G$ kept below the coercive field of the ferroelectric layer (see Figure 13d). Here the transconductance value has been normalized considering the drop of potential over the P(VDF-TrFE) layer.

**Claims**

1.  An electrochemical device (100, 300, 800) comprising:

    an electrochemically active polymer layer (101, 301, 801);
    a ferroelectric layer (102, 302, 802); and
    an ion conductor layer (103, 303, 803) arranged between said electrochemically active layer and said ferroelectric layer and in contact with the electrochemically active layer,
    **characterized in that** the electrochemically active polymer layer comprises a polymer selected from the group consisting of a homopolymer or copolymer of a 3,4-dialkoxythiophene, in which said two alkoxy groups may be the same or different or together represent an optionally substituted oxy-alkylene-oxy bridge.

2.  An electrochemical device according to claim 1, further comprising:

    an electrode (104, 304, 804) arranged in electronic contact with the said ferroelectric layer;
    said ferroelectric layer being arranged between said electrode and said ion conductor layer.

3.  An electrochemical device according to claim 2, wherein the electrochemical device is an electrochromic pixel.

4.  An electrochemical device according to claim 1, wherein the electrochemical device is an electrochemical transistor further comprising:

    a source electrode (306a, 806a) arranged in electronic contact with the said electrochemically active layer;
    a drain electrode (306b, 806b) arranged in electronic contact with the said electrochemically active layer; and
    a gate electrode (304, 804);
    said ferroelectric layer being arranged between said gate electrode and said ion conductor layer.

5.  An electrochemical device according to any one of the preceding claims wherein, the ratio between the ferroelectric layer surface charge and the electrochemically active layer bulk charge is larger than 1:1.

6.  An electrochemical device according to any one of the preceding claims wherein the ferroelectric layer:electrochemically active layer area ratio is larger than 1:1, preferably larger than 2:1, larger than 4:1, larger than 8:1, or larger than 10:1.

7.  The electrochemical device according to any one of the preceding claims, wherein the electrochemically active polymer layer, the ferroelectric layer and/or the ion conductor layer comprise organic materials.

8.  The electrochemical device according to any one of the preceding claims, wherein the electrochemically active polymer layer comprises a polymer which is electrically conducting in at least one oxidation state, and optionally also comprises an anionic or polyanionic compound.

9.  The electrochemical device according to any one of the preceding claims, wherein the electrochemically active polymer layer comprises an electrochromic polymer.

10. The electrochemical device according to any one of the preceding claims, wherein the electrochemically active polymer layer further comprises a polyanionic compound, preferably poly(styrene sulfonate).

11. The electrochemical device according to any one of the preceding claims, wherein the ferroelectric layer comprises a ferroelectric polymer and/ or wherein the ion conductor layer comprises a polymeric electrolyte.

12. The electrochemical device according to any one of claims 2-11, further comprising a metal interlayer (105, 305), said metal interlayer being arranged between said ferroelectric layer and said ion conductor layer.

**13.** The electrochemical device according to any one of claims 2-12, further comprising a polymeric interlayer (307), said polymeric interlayer being arranged between said electrode arranged in electronic contact with the said ferroelectric layer, and said ferroelectric layer.

**14.** Use of an ion conductor layer (103, 303, 803) between a ferroelectric layer (102, 302, 802) and an electrochemically active polymer layer (101, 301, 801) of an electrochemical device (100, 300, 800), according to independent claim 1, to introduce a threshold voltage for initiating an electrochemical reaction in the electrochemically active polymer layer.

**Patentansprüche**

**1.** Elektrochemische Vorrichtung (100, 300, 800), umfassend:

eine elektrochemisch aktive Polymerschicht (101, 301, 801);
eine ferroelektrische Schicht (102, 302, 802); und
eine lonenleiterschicht (103, 303, 803), die zwischen der elektrochemisch aktiven Schicht und der ferroelektrischen Schicht angeordnet ist und mit der elektrochemisch aktiven Schicht in Kontakt steht, **dadurch gekennzeichnet, dass** die elektrochemisch aktive Polymerschicht ein Polymer umfasst, ausgewählt aus der Gruppe bestehend aus einem Homopolymer oder Copolymer eines 3,4-Dialkoxythiophens, in dem die beiden Alkoxygruppen gleich oder verschieden sein können oder zusammen eine gegebenenfalls substituierte Oxy-alkylen-oxy-brücke darstellen.

**2.** Elektrochemische Vorrichtung nach Anspruch 1, ferner umfassend:

eine Elektrode (104, 304, 804), die in elektronischem Kontakt mit der ferroelektrischen Schicht angeordnet ist;
wobei die ferroelektrische Schicht zwischen der Elektrode und der lonenleiterschicht angeordnet ist.

**3.** Elektrochemische Vorrichtung nach Anspruch 2, wobei die elektrochemische Vorrichtung ein elektrochromes Pixel ist.

**4.** Elektrochemische Vorrichtung nach Anspruch 1, wobei die elektrochemische Vorrichtung ein elektrochemischer Transistor ist, ferner umfassend:

eine Quellenelektrode (306a, 806a), die in elektronischem Kontakt mit der elektrochemisch aktiven Schicht angeordnet ist;
eine Drainelektrode (306b, 806b), die in elektronischem Kontakt mit der elektrochemisch aktiven Schicht angeordnet ist; und
eine Gateelektrode (304, 804);
wobei die ferroelektrische Schicht zwischen der Gateelektrode und der lonenleiterschicht angeordnet ist.

**5.** Elektrochemische Vorrichtung nach einem der vorhergehenden Ansprüche, wobei das Verhältnis zwischen der Oberflächenladung der ferroelektrischen Schicht und der Massenladung der elektrochemisch aktiven Schicht größer als 1:1 ist.

**6.** Elektrochemische Vorrichtung nach einem der vorhergehenden Ansprüche, wobei das Flächenverhältnis von ferroelektrischer Schicht zu elektrochemisch aktiver Schicht größer als 1:1, vorzugsweise größer als 2:1, größer als 4:1, größer als 8:1 oder größer als ist 10:1.

**7.** Elektrochemische Vorrichtung nach einem der vorhergehenden Ansprüche, wobei die elektrochemisch aktive Polymerschicht, die ferroelektrische Schicht und / oder die lonenleiterschicht organische Materialien umfassen.

**8.** Elektrochemische Vorrichtung nach einem der vorhergehenden Ansprüche, wobei die elektrochemisch aktive Polymerschicht ein Polymer umfasst, das in mindestens einer Oxidationsstufe elektrisch leitend ist, und gegebenenfalls auch eine anionische oder polyanionische Verbindung umfasst.

**9.** Elektrochemische Vorrichtung nach einem der vorhergehenden Ansprüche, wobei die elektrochemisch aktive Polymerschicht ein elektrochromes Polymer umfasst.

**10.** Elektrochemische Vorrichtung nach einem der vorhergehenden Ansprüche, wobei die elektrochemisch aktive Polymerschicht ferner eine polyanionische Verbindung, vorzugsweise Poly(styrolsulfonat), umfasst.

**11.** Elektrochemische Vorrichtung nach einem der vorhergehenden Ansprüche, wobei die ferroelektrische Schicht ein ferroelektrisches Polymer umfasst und / oder wobei die Ionenleiterschicht einen polymeren Elektrolyten umfasst.

**12.** Elektrochemische Vorrichtung nach einem der Ansprüche 2 bis 11, ferner umfassend eine Metallzwischenschicht (105, 305), wobei die Metallzwischenschicht zwischen der ferroelektrischen Schicht und der Ionenleiterschicht angeordnet ist.

**13.** Elektrochemische Vorrichtung nach einem der Ansprüche 2 bis 12, ferner umfassend eine polymere Zwischenschicht (307), wobei die polymere Zwischenschicht zwischen der Elektrode, die in elektronischem Kontakt mit der ferroelektrischen Schicht angeordnet ist, und der ferroelektrischen Schicht angeordnet ist.

**14.** Verwendung einer Ionenleiterschicht (103, 303, 803) zwischen einer ferroelektrischen Schicht (102, 302, 802) und einer elektrochemisch aktiven Polymerschicht (101, 301, 801) einer elektrochemischen Vorrichtung (100, 300, 800), nach unabhängigem Anspruch 1, zur Einführung einer Schwellenspannung zum Auslösen einer elektrochemischen Reaktion in der elektrochemisch aktiven Polymerschicht.

**Revendications**

1. Dispositif électrochimique (100, 300, 800) comprenant :

    une couche de polymère électrochimiquement active (101, 301, 801) ;
    une couche ferroélectrique (102, 302, 802) ; et
    une couche conductrice d'ions (103, 303, 803) disposée entre ladite couche électrochimiquement active et ladite couche ferroélectrique et en contact avec la couche électrochimiquement active,
    **caractérisé en ce que** la couche de polymère électrochimiquement active comprend un polymère choisi dans le groupe constitué par un homopolymère ou un copolymère d'un 3,4-dialcoxythiophène, dans lequel lesdits deux groupes alcoxy peuvent être identiques ou différents ou bien représentent ensemble un pont oxy-alkylène-oxy éventuellement substitué.

2. Dispositif électrochimique selon la revendication 1, comprenant en outre :

    une électrode (104, 304, 804) disposée en contact électronique avec ladite couche ferroélectrique ;
    ladite couche ferroélectrique étant disposée entre ladite électrode et ladite couche conductrice d'ions.

3. Dispositif électrochimique selon la revendication 2, dans lequel le dispositif électrochimique est un pixel électrochrome.

4. Dispositif électrochimique selon la revendication 1, dans lequel le dispositif électrochimique est un transistor électrochimique comprenant en outre :

    une électrode source (306a, 806a) disposée en contact électronique avec ladite couche électrochimiquement active ;
    une électrode de drain (306b, 806b) disposée en contact électronique avec ladite couche électrochimiquement active ; et
    une électrode de grille (304, 804) ;
    ladite couche ferroélectrique étant disposée entre ladite électrode de grille et
    ladite couche conductrice d'ions.

5. Dispositif électrochimique selon l'une quelconque des revendications précédentes, dans lequel le rapport entre la charge de surface de la couche ferroélectrique et la charge volumique de la couche électrochimiquement active est supérieur à 1:1.

6. Dispositif électrochimique selon l'une quelconque des revendications précédentes, dans lequel le rapport de surface couche ferroélectrique:couche électrochimiquement active est supérieur à 1:1, de préférence supérieur à 2:1, supérieur à 4:1, supérieur à 8:1 ou supérieur à 10:1.

7. Dispositif électrochimique selon l'une quelconque des revendications précédentes, dans lequel la couche de polymère électrochimiquement active, la couche ferroélectrique et/ou la couche conductrice d'ions comprennent des matériaux organiques.

8. Dispositif électrochimique selon l'une quelconque des revendications précédentes, dans lequel la couche de polymère électrochimiquement active comprend un polymère qui est électriquement conducteur dans au moins un état d'oxydation, et comprend de manière facultative également un composé anionique ou polyanionique.

9. Dispositif électrochimique selon l'une quelconque des revendications précédentes, dans lequel la couche de polymère électrochimiquement active comprend un polymère électrochrome.

10. Dispositif électrochimique selon l'une quelconque des revendications précédentes, dans lequel la couche de polymère électrochimiquement active comprend en outre un composé polyanionique, de préférence du poly(styrène sulfonate).

11. Dispositif électrochimique selon l'une quelconque des revendications précédentes, dans lequel la couche ferroélectrique comprend un polymère ferroélectrique et/ou dans lequel la couche conductrice d'ions comprend un électrolyte polymère.

12. Dispositif électrochimique selon l'une quelconque des revendications 2 à 11, comprenant en outre une couche intermédiaire métallique (105, 305), ladite couche intermédiaire métallique étant disposée entre ladite couche ferroélectrique et ladite couche conductrice d'ions.

13. Dispositif électrochimique selon l'une quelconque des revendications 2 à 12, comprenant en outre une couche intermédiaire polymère (307), ladite couche intermédiaire polymère étant disposée entre ladite électrode disposée en contact électronique avec ladite couche ferroélectrique, et ladite couche ferroélectrique.

14. Utilisation d'une couche conductrice d'ions (103, 303, 803) entre une couche ferroélectrique (102, 302, 802) et une couche de polymère électrochimiquement active (101, 301, 801) d'un dispositif électrochimique (100, 300, 800), selon à la revendication indépendante 1, pour introduire une tension de seuil pour déclencher une réaction électrochimique dans la couche de polymère électrochimiquement active.

*Fig. 1*

EP 3 226 271 B1

*Fig. 2*

EP 3 226 271 B1

*Fig. 3*

Fig. 4

Fig. 5

Fig. 6

Fig. 7

Fig. 8

(a)

(b)

*Fig. 9*

(a)

(b)

*Fig. 10*

Fig. 11

*Fig. 12*

Fig. 13

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2779261 A1
- EP 1798732 A1, GELINCK G
- US 2006160251 A1

**Non-patent literature cited in the description**

- All-polymer ferroelectric transistors. APPLIED PHYSICS LETTERS. A I P PUBLISHING LLC, 23 August 2005, vol. 87, 92903-092903